# FASCICULE DE BREVET EUROPEEN

(11) **EP 0 531 230 B1**
(45) Date de publication et mention de la délivrance du brevet: **11.09.1996**
(21) Numéro de dépôt: 92420212.0
(22) Date de dépôt: 23.06.1992
(51) Int. Cl.: G01R 27/18, G01R 31/02

(54) **Dispositif de distribution d'énergie électrique avec contrôle d'isolement**
Verteilungsvorrichtung für elektrische Energie mit Isolationskontrolle
Electrical energy distributing device with monitoring of isolation

(30) Priorité: 09.07.1991 FR 9108715
(43) Date de publication de la demande: 10.03.1993
(73) Titulaire: SCHNEIDER ELECTRIC SA, F-92100 Boulogne-Billancourt (FR)
(72) Inventeur: Barjonnet, Jean-Paul, F-38050 Grenoble Cedex 9 (FR); Vincent, François, F-38050 Grenoble Cedex 9 (FR)
(74) Mandataire: Hecké, Gérard

(56) Documents cités:
- EP-A- 0 291 755
- EP-A- 0 398 824
- GB-A- 2 235 982
- US-A- 4 947 278

## Description

La présente invention se rapporte à une installation de distribution d'énergie électrique avec contrôle d'isolement.

Le document FR-A-2.647.220 décrit une installation de distribution d'énergie électrique qui comporte un seul réseau d'alimentation alternative triphasée à neutre isolé. Le réseau est équipé d'un contrôleur d'isolement global numérique qui injecte sur celui-ci une tension alternative auxiliaire dite tension d'injection, de fréquence généralement comprise entre 4 et 10 hertz.

En cas de défaut d'isolement, le contrôleur global d'isolement mesure, par un procédé classique de démodulation synchrone, les valeurs de la résistance de fuite et de la capacité de fuite qui sont dues au défaut. La détermination est réalisée par la mesure préalable de la tension d'injection ainsi que du courant de fuite dans l'impédance de fuite due au défaut.

Un perfectionnement du dispositif consiste à prévoir, sur chaque dérivation, ou départ, du réseau triphasé un tore de mesure d'intensité qui est relié à un contrôleur local d'isolement, dit localisateur.Le localisateur fonctionne de la même façon que le contrôleur d'isolement global, c'est à dire par démodulation synchrone, mais la valeur de tension d'injection Ui qu'il utilise lui est directement transmise par le contrôleur d'isolement global, tandis que bien entendu la valeur du courant de fuite local est mesurée par le ou les tores de mesure qui équipent la ou les branches de la dérivation.

Le contrôleur global d'isolement transmet d'autre part à chaque localisateur des impulsions de synchronisation des sinusoïdes de référence qui sont utilisées pour la démodulation synchrone.

Dans le cas, concerné par la présente invention, où l'installation électrotechnique comporte plusieurs réseaux de distribution distincts, ayant chacun un contrôleur global d'isolement, il faut éviter d'avoir une configuration telle que plusieurs contrôleurs d'isolement global soient simultanément en service sur les mêmes utilisateurs, ce qui entraînerait une impossibilité d'utilisation des contrôleurs. La technique classique utilisable pour résoudre la difficulté, consisterait à prévoir un ensemble de relais, à circuiterie extrêmement complexe, pour déconnecter certains contrôleurs d'isolement global quand celà s'avère nécessaire en raison des configurations utilisées. Cette solution a pour inconvénient d'être particulièrement compliquée et onéreuse.

L'invention vise à remédier à cet inconvénient. Elle se rapporte à un dispositif de distribution d'énergie électrique comportant:
- plusieurs sources d'alimentation, associées chacune à un contrôleur global d'isolement, chaque source alimentant par un jeu de barres une pluralité de dérivations via au moins un disjoncteur, ledit contrôleur global d'isolement étant agencé pour mesurer la résistance de fuite par démodulation synchrone de la tension d'injection et du courant de fuite;
- un organe de mesure local d'intensité de courant de fuite agencé dans .chaque dérivation, ledit organe comprenant notamment un tore homopolaire;
- un contrôleur local d'isolement ou localisateur connecté aux organes de mesure des dérivations associées à chaque source d'alimentation, chaque localisateur recevant une mesure locale du courant de fuite dans chaque dérivation;
- une liaison informatique reliant chaque contrôleur global d'isolement à chaque localisateur associé;
- une pluralité de disjoncteurs de liaison, agencés entre les sources d'alimentation pour réaliser une configuration électrotechnique prédéterminée,
caractérisé en ce que l'ensemble des liaisons informatiques est conformé en un seul réseau local de transmission, et que des moyens de mesure, de calcul, et d'actionnement, sont prévus pour élaborer et pour recueillir des données représentatives de l'état ouvert ou fermé de chacun desdits disjoncteurs et pour transmettre, via le réseau local, des ordres d'exclusion vers les contrôleurs d'isolement global qui se trouvent, selon la configuration électrotechnique de chaque portion d'installation alimentée, sur la même configuration, à l'exception d'un seul de ceux-ci qui fonctionne en pilote sur ladite portion après transmission des informations, à tous les localisateurs de la portion via ledit réseau local.

De toute façon, l'invention sera bien comprise, et ses avantages et autres caractéristiques ressortiront, lors de la description suivante de deux exemples non limitatifs de réalisation, en référence au dessin schématique annexé dans lequel:
La figure 1 est un schéma synoptique de l'installation dans un cas général;
La figure 2 est une représentation d'un graphe utilisé pour la gestion de l'installation selon la figure 1; et
La figure 3 représente de la même façon que sur la figure 1, une installation de même type, mais dans une configuration très simplifiée;

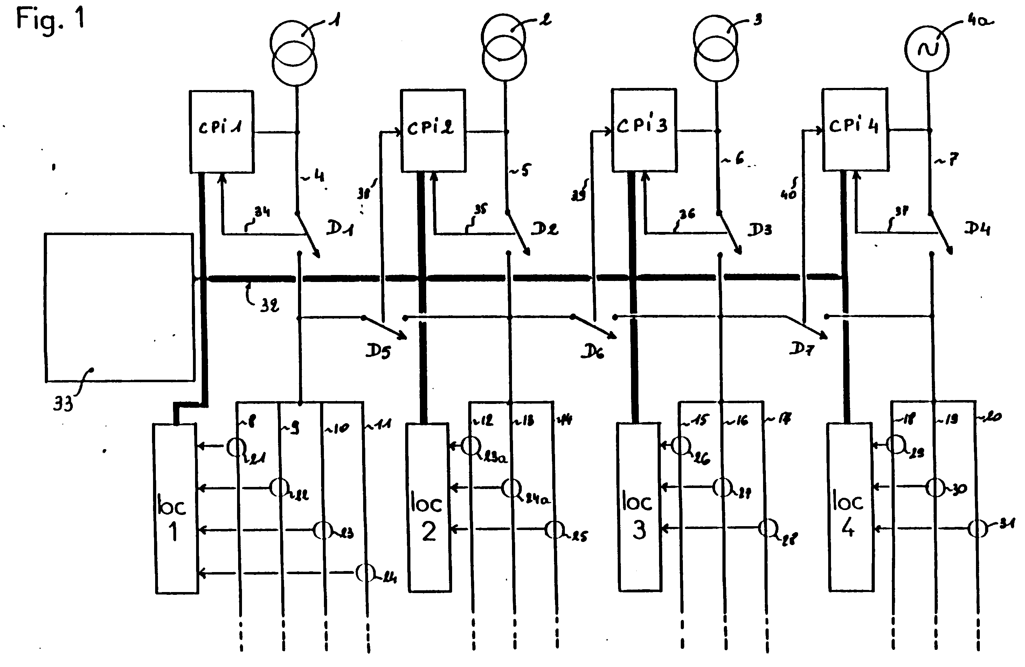

En se référant à la figure 1, il est représenté une installation électrotechnique d'alimentation en énergie électrique alternative triphasée à neutre isolé. Dans cet exemple, l'installation électrotechnique comprend trois sources d'alimentation distinctes 1,2,3, débitant chacune sur un jeu de barres, respectivement 4,5,6, et un générateur électrique 4a débitant sur un jeu de barres 7. Chaque jeu de barres 4 à 7 est normalement prévu pour alimenter, via un disjoncteur respectif D1 à D4, sa propre configuration électrotechnique qui est constituée,dans cet exemple relativement simple,par un certain nombre de dérivations, ou départs:
- dérivations 8 à 11 pour le jeu de barres 4;
- dérivations 12 à 14 pour le jeu de barres 5;
- dérivations 15 à 17 pour le jeu de barres 6; et
- dérivations 18 à 20 pour le jeu de barres 7.

De plus, les quatre configurations élémentaires peuvent être, selon les besoins, interconnectées via des disjoncteurs de liaison D5, D6, et D7.

Enfin, chacune des quatre configurations élementaires est munie d'un dispositif de contrôle numérique d'isolement, semblable pour chacune d'elles, et comprenant par exemple pour la première configuration élémentaire (1,4,8 à 11):
- un contrôleur global d'isolement CPI1, par exemple semblable à celui décrit dans le document FR-A-2.647.220 précité, qui est branché sur le jeu de barres 4 entre le réseau 1 et le disjoncteur D1. Le contrôleur CPI1 mesure la résistance de fuite par démodulation synchrone de sa tension d'injection Ui et du courant de fuite If; et
- un contrôleur local d'isolement LOC1, ou localisateur, qui reçoit une mesure locale du courant de fuite dans chacune des dérivations 8 à 11 grâce à des tores homopolaires de mesure 21 à 24, et qui calcule, toujours par démodulation synchrone, l'impédance locale de fuite en utilisant, d'une part la mesure locale, et d'autre part la mesure de le tension injectée Ui qui lui est transmise par le contrôleur d'isolement global CPI1 via une liaison informatique 32.

Il en est de même pour les trois autres configurations élémentaires précitées (voir les tores 23 à 31 et les localisateurs LOC2 et LOC4), et en fait la liaison informatique 32 constitue un réseau local qui relie ensemble tous les contrôleurs d'isolement global CPI1 à CPI4, et tous les localisateurs LOC1 à LOC4. En outre, le réseau local 32 relie les huit appareils à une unité centrale de gestion 33.

Par ailleurs,chaque disjoncteur D1 à D7 est équipé d'un moyen de test, constitué par exemple par un micro-contact auxiliaire classique, qui est apte à communiquer, via une liaison électrique respective 34 à 40, une information représentative de son état ouvert ou fermé à l'un des contrôleurs d'isolement CPI1 à CPI4, de façon que cet état puisse être transmis, via le réseau local 32, à l'unité de gestion 33.

Tant que les quatre configurations élémentaires précitées fonctionnent séparément, c'est à dire si tous les disjoncteurs d'interconnexion D5 à D7 sont ouverts, aucune difficulté particulière ne se pose. En revanche, le système de contrôle d'isolement ne peut plus fonctionner si plusieurs des configurations élémentaires sont interconnectées, par exemple les trois premières si les disjoncteurs D5 et D6 sont fermés, du fait que les contrôleurs d'isolement global, CPI1 à CPI3 dans cet exemple, alors interconnectés électriquement, injecteraient l'un dans l'autre.

Pour rémédier à cette difficulté, l'unité de gestion 33 place alors autoritairement, via le réseau local 32, les contrôleurs d'isolement global CPI2 et CPI3 en mode exclu, c'est à dire qu'ils n'injectent plus rien. Le seul contrôleur global d'isolement restant est le contrôleur CPI1 qui fonctionne en pilote par injection de la tension Ui sur l'ensemble des trois configurations élémentaires et par transmission des données démodulées de la tension à tous les localisateurs LOC1 à LOC3 de l'ensemble.

Bien entendu, la configuration restante 4,7,18 à 20, qui restent indépendante du fait que le disjoncteur de liaison D7 est ouvert, continue à fonctionner seule avec ses deux contrôleurs CPI4 et LOC4.

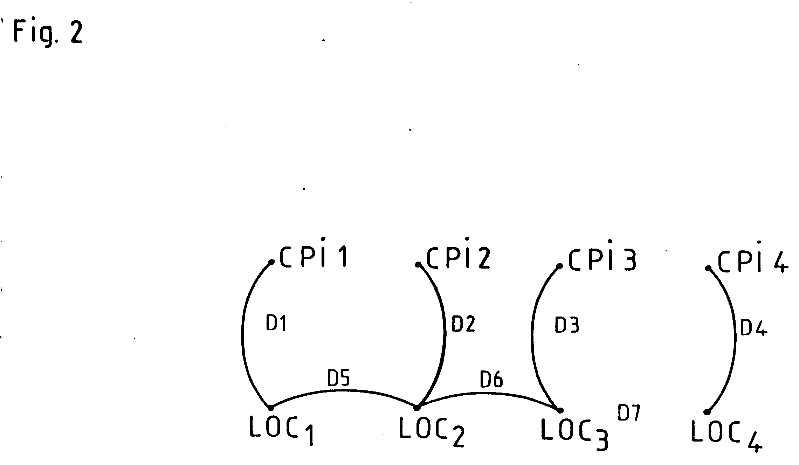

L'unité de gestion 33 procède au moyen de graphes, dont un exemple est représenté sur la figure 2 pour la configuration électrique ci-dessus (disjoncteurs D1 à D6 fermés, disjoncteur D7 ouvert).

Sur ce graphe, les appareils CPI1 à CPI4, LOC1 à LOC4, sont des sommets, tandis que les disjoncteurs D1 à D7 sont des arcs.Un arc existe si le disjoncteur correspondant est fermé, et n'existe pas dans le cas contraire.

La configuration électrique précitée donne alors le graphe représenté sur la figure 2, qui montre nettement à l'unité 33 que les trois contrôleurs CPI1 à CPI3 sont sur une même configuration, de sorte qu'il y a lieu d'en placer autoritairement deux en mode exclu, le dernier étant le pilote. Le choix du pilote est effectué par l'unité 33 selon un programme établi à l'avance, et cette dernière donne les ordres d'injection ou d'exclusion à tous les CPI et, pour chaque localisateur, l'adresse du contrôleur pilote.

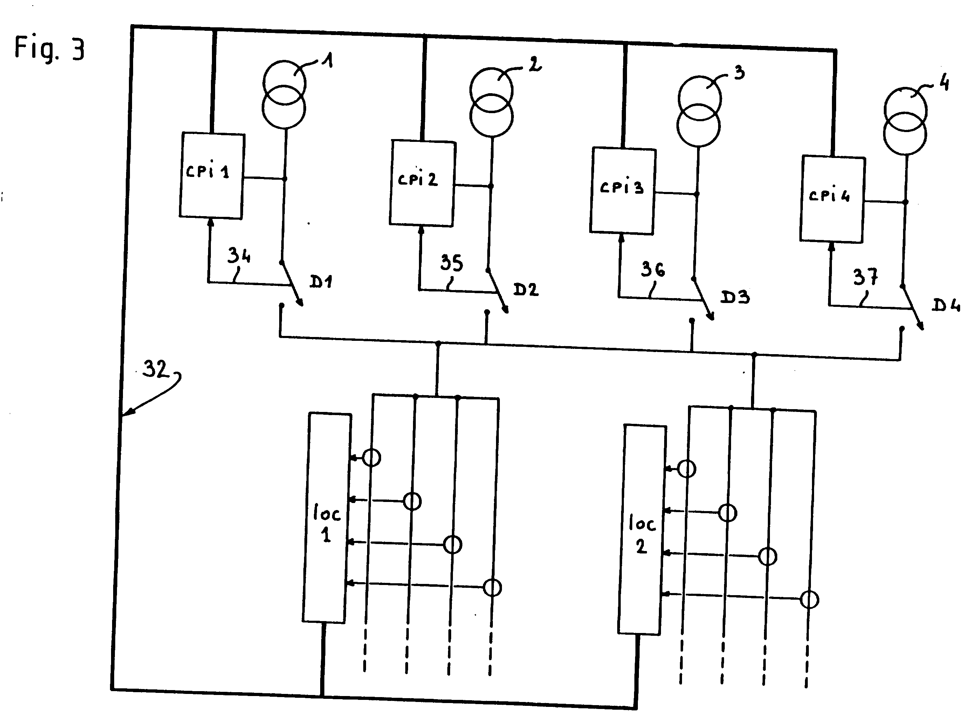

Dans le cas des configurations électrotechniques très simples, telle que par exemple celle représentée sur la figure 3, comportant par exemple quatre contrôleurs d'isolement global CPI1 à CPI4 et quatre disjoncteurs D1 à D4, l'unité de gestion n'est pas nécessaire.

Le mode de fonctionnement de chaque contrôleur CPI1,CPI2,CPI3,CPI4 est déterminé par le contrôleur lui même en fonction de l'état du contact du disjoncteur D1,D2,D3,D4. Si le contact est ouvert,le contrôleur correspondant CPI injecte mais n'envoie pas la tension UI aux localisateurs. Si le contact est fermé, et en fonction du code adresse propre à chaque appareil et nécessaire aux bonnes communications sur la liaison informatique 32, chaque contrôleur décide s'il devient pilote ou exclu. L'appareil ayant l'adresse la plus petite devient pilote, les autres deviennent exclus.

## Revendications

1. Dispositif de distribution d'énergie électrique comportant:
- plusieurs sources d'alimentation (1,2,3,4a), associées chacune à un contrôleur global d'isolement (CPI1,CPI2,CPI3, CPI4), chaque source alimentant par un jeu de barres (4,5,6,7) une pluralité de dérivations (8,9,10,11; 12,13,14; 15,16,17; 18,19,20) via au moins un disjoncteur (D1,D2,D3,D4), ledit contrôleur global d'isolement étant agencé pour mesurer la résistance de fuite par démodulation synchrone de la tension d'injection (Ui) et du courant de fuite (If);
- un organe de mesure local d'intensité de courant de fuite agencé dans chaque dérivation, ledit organe comprenant notamment un tore homopolaire (21 à 31);
- un contrôleur local d'isolement (LOC1,LOC2,LOC3,LOC4) connecté aux organes de mesure des dérivations associées à chaque source d'alimentation (1,2,3,4), chaque contrôleur local d'isolement recevant une mesure locale du courant de fuite dans chaque dérivation;
- une liaison informatique reliant chaque contrôleur global d'isolement (CP1,CP2,CP3,CP4) à chaque contrôleur local d'isolement associé (LOC1,LOC2,LOC3,LOC4);
- une pluralité de disjoncteurs de liaison (D5,D6,D7) agencés entre les sources d'alimentation (1,2,3,4a) pour réaliser une configuration électrotechnique prédéterminée,
caractérisé en ce que
l'ensemble des liaisons informatiques est conformé en un seul réseau local (32) de transmission, et que des moyens (34 à 40) de mesure, de calcul, et d'actionnement, sont prévus pour élaborer et pour recueillir des données représentatives de l'état ouvert ou fermé de chacun desdits disjoncteurs (D1 à D7) et pour transmettre, via le réseau local (32), des ordres d'exclusion vers les contrôleurs globaux d'isolement (CPI2 et CPI3) qui se trouvent, selon la configuration électrotechnique de chaque portion d'installation alimentée, sur la même configuration, à l'exception d'un seul de ceux-ci (CPI1) qui fonctionne en pilote sur ladite portion après transmission des informations, à tous les contrôleurs locaux d'isolement (LOC1,LOC2,LOC3) de la portion via ledit réseau local (32).

2. Dispositif de distribution selon la revendication 1, caractérisé en ce qu'un organe de gestion (33) est branché sur ledit réseau local (32), pour reçevoir les informations de l'état desdits disjoncteurs (D1 à D7) et pour transmettre des informations d'exclusion ou de fonctionnement à tous les contrôleurs globaux d'isolement (CPI1 à CPI4), ainsi que l'indication du contrôleur pilote à tous les contrôleurs locaux d'isolement (LOC1 à LOC4).

3. Dispositif de distribution selon la revendication 2, caractérisé en ce que l'organe de gestion (33) utilise des graphes avec des sommets constitués par les contrôleurs globaux et locaux d'isolement (CPI1 à CPI4 ; L0C1 à L0C4) et des arcs reliant ou ne reliant pas ces sommets selon l'état, ouvert ou fermé, des disjoncteurs (D1 à D7), chaque disjoncteur étant représenté par un arc.

4. Dispositif de distribution selon la revendication 1, caractérisé en ce que chaque contrôleur d'isolement global sert d'organe de gestion apte à décider de son propre fonctionnement ou de son exclusion des autres contrôleurs d'isolement global (CPI2 à CPI4).

5. Dispositif de distribution selon la revendication 1, caractérisé en ce que chaque disjoncteur (D1 à D7) comporte des moyens (34 à 40) de test pour détecter l'état ouvert ou fermé, et des moyens de transmission de l'état à un contrôleur global d'isolement associé (CPI1 à CPI4).

## Patentansprüche

1. Elektrische Verteilung mit
- mehreren Einspeisungen (1, 2, 3, 4a), die jeweils einem Gesamt-Isolationswächter (CPI1, CPI2, CPI3, CPI4) zugeordnet sind, wobei jede Einspeisung über ein Sammelschienensystem (4, 5, 6, 7) und jeweils mindestens einen Leistungsschalter (D1, D2, D3, D4) mehrere Zweige (8, 9, 10, 11; 12, 13, 14; 15, 16, 17; 18, 19, 20) versorgt und der genannte Gesamt-Isolationswächter so ausgelegt ist, daß er durch Synchron-Demodulation der Prüfspannung (Ui) und des Fehlerstroms (If) den Fehlerwiderstand mißt,
- einer in jeden Zweig eingesetzten örtlichen Meßeinrichtung zur Erfassung des Fehlerstroms, wobei die genannte Meßeinrichtung insbesondere einen Fehlerstrom-Meßwandler (21 bis 31) umfaßt,
- einem an die Meßeinrichtungen der den einzelnen Einspeisungen (1, 2, 3, 4a) zugeordneten Zweige angeschlossenen, örtlichen Isolationswächter (LOC1, LOC2, LOC3, LOC4), wobei jeder örtliche Isolationswächter einen örtlichen Meßwert des Fehlerstroms im betreffenden Zweig erfaßt,
- einer EDV-Steuerleitung, die jeden Gesamt-Isolationswächter (CPI1, CPI2, CPI3, CPI4) mit jedem zugeordneten örtlichen Isolationswächter (LOC1, LOC2, LOC3, LOC4) verbindet,
- mehreren zwischen den einzelnen Einspeisungen (1, 2, 3, 4a) angeordneten Kopplungs-Leistungsschaltern (D5, D6, D7) zur Herstellung einer bestimmten Netzkonfiguration,
dadurch gekennzeichnet, daß
sämtliche EDV-Steuerleitungen zu einem einzigen lokalen Datenübertragungsnetz (32) zusammengefaßt sind und die Meß-, Rechen- und Wirkorgane (34 bis 40) zur Erzeugung und Aufnahme der den Einoder Ausschaltzustand jedes der genannten Leistungsschalter (D1 bis D7) abbildenden Daten sowie zur Übertragung von Blockierbefehlen über das lokale Netz an die Gesamt-Isolationswächter (CPI2 und CPI3) dienen, die sich je nach Konfiguration der einzelnen eingespeisten Installationsabschnitte im gleichen Konfigurationsabschnitt befinden, wobei einer der Gesamt-Isolationswächter (CPI1) davon ausgenommen ist und nach Übertragung der Daten über das genannte lokale Netz (32) an sämtliche örtlichen Isolationswächter (LOC1, LOC2, LOC3) des Installationsabschnitts als Leitsystem für den genannten Abschnitt arbeitet.

2. Verteilung nach Anspruch 1, dadurch gekennzeichnet, daß eine Zentralsteuerung (33) mit dem genannten lokalen Netz (32) verbunden ist, um die Informationen über den Schaltzustand der genannten Leistungsschalter (D1 bis D7) aufzunehmen und Blockier- bzw. Betriebsbefehle an sämtliche Gesamt-Isolationswächter (CPI1 bis CPI4) zu übertragen sowie die Information über den als Leitsystem arbeitenden Gesamt-Isolationswächter an alle örtlichen Isolationswächter (LOC1 bis LOC4) weiterzuleiten.

3. Verteilung nach Anspruch 2, dadurch gekennzeichnet, daß die Zentralsteuerung (33) mit Hilfe von Steuergraphen mit durch die Gesamt-bzw. örtlichen Isolationswächter (CPI1 bis CPI4; LOC1 bis LOC4) dargestellten Graphenspitzen sowie diese Spitzen, je nach Ein- oder Ausschaltzustand der Leistungsschalter (D1 bis D7) verbindende oder nicht verbindende Übergangsbögen, wobei jeder Leistungsschalter durch einen Übergangsbogen dargestellt ist.

4. Verteilung nach Anspruch 1, dadurch gekennzeichnet, daß jeder Gesamt-Isolationswächter als Steuerorgan arbeitet, welches in der Lage ist, über seinen eigenen Betrieb bzw. seine Blockierung gegenüber den übrigen Gesamt-Isolationswächtern (CPI2 bis CPI4) zu entscheiden.

5. Verteilung nach Anspruch 1, dadurch gekennzeichnet, daß jeder Leistungsschalter (D1 bis D7) Prüfeinrichtungen (34 bis 40) zur Erfassung des Ein- bzw. Ausschaltzustands sowie Mittel zur Übertragung der Schaltzustandsinformation an einen zugeordneten Gesamt-Isolationswächter (CPI1 bis CPI4) umfaßt.

## Claims

1. An electrical power distribution device comprising :
- several power supply sources (1,2,3,4a), each associated to a global isolation monitor (CPI1,CPI2,CPI3,CPI4), each source supplying by means of a busbar (4,5,6,7) a plurality of feeders (8,9,10,11; 12,13,14; 15,16,17; 18,19,20) via at least one circuit breaker (D1,D2,D3,D4), said global isolation monitor being arranged to measure the leakage resistance by synchronous demodulation of the input voltage (Ui) and leakage current (If;)
- a local measuring device, arranged in each feeder, for measuring the leakage current intensity, said device notably comprising a ground fault toroid (21 to 31);
- a local isolation monitor (LOC1,LOC2,LOC3,LOC4) connected to the measuring devices of the feeders associated to each power supply source (1,2,3,4), each local isolation monitor receiving a local measurement of the leakage current in each feeder;
- a computer line connecting each global isolation monitor (CPI1,CPI2,CPI3,CPI4) to each associated local isolation monitor (LOC1,LOC2, LOC3,LOC4);
- a plurality of connecting circuit breakers (D5,D6,D7) arranged between the power supply sources (1,2,3,4a) to achieve a predetermined electrotechnical configuration,
characterized in that
the set of computer lines forms a single local transmission network (32), and that means (34 to 40) for measuring, computing, and actuation, are provided to generate and to collect data representative of the open or closed state of each of said circuit breakers (D1 to D7) and to transmit, via the local network (32), exclusion orders to the global isolation monitors (CPI2 and CPI3) which are, depending on the electro-technical configuration of each portion of installation supplied, on the same configuration, with the exception of a single one of them (CPI1) which operates as pilot on said portion after transmission of the information to all the local isolation monitors (LOC1,LOC2,LOC3,LOC4) of the portion via said local network (32).

2. The distribution device according to claim 1, characterized in that a management unit (33) is connected to said local network (32) to receive the status information of said circuit breakers (D1 to D7) and to transmit exclusion or operation information to all the global isolation monitors (CPI1 to CPI4), and indication of the pilot monitor to all the local isolation monitors (LOC1,LOC2,LOC3,LOC4).

3. The distribution device according to claim 2, characterized in that the management unit (33) uses graphs with peaks formed by the global and local isolation monitors (CPI1 to CPI4 ; LOC1 to LOC4) and arcs connecting or not connecting these peaks according to the open or closed state of the circuit breakers (D1 to D7), each circuit breaker being represented by an arc.

4. The distribution device according to claim 1, characterized in that each global isolation monitor acts as management unit able to decide its own operation or its exclusion from the other global isolation monitors (CPI2 to CPI4).

5. The distribution device according to claim 1, characterized in that each circuit breaker (D1 to D7) comprises test means (34 to 40) for detecting the open or closed state, and means for transmitting the state to an associated global isolation monitor (CPI1 to CPI4).
